# EUROPEAN PATENT APPLICATION

(11) **EP 4 831 663 A1**
(43) Date of publication of application: **28.10.2026**
(21) Application number: 23961693.1
(22) Date of filing: 18.12.2023
(51) Int. Cl.: G01R 31/385, G01R 31/392, G01R 31/3835, H01M 10/48

(54) **OCV MEASUREMENT METHOD AND OCV MEASUREMENT DEVICE**

(71) Applicant: Nissan Motor Co., Ltd., Yokohama-shi, Kanagawa 221-0023 (JP)
(72) Inventor: NAGAE Daisuke, Atsugi-shi, Kanagawa 243-0123 (JP); NAKANO Keisuke, Atsugi-shi, Kanagawa 243-0123 (JP); AOYAMA Rei, Atsugi-shi, Kanagawa 243-0123 (JP); SUZUKI Kohei, Atsugi-shi, Kanagawa 243-0123 (JP); NARUKAMI Hisakazu, Atsugi-shi, Kanagawa 243-0123 (JP)
(74) Representative: Grünecker Patent- und Rechtsanwälte PartG mbB
(86) International application number: PCT/JP2023/045337
(87) International publication number: WO 2025/134203

(57) **Abstract**

Provided is an OCV measurement method and an OCV measurement device capable of grasping a state of health of a secondary battery mounted on a vehicle with high precision by enabling a measurement of OCV with high precision to be performed even when the secondary battery is in a low SOC state. The OCV measurement method includes: when the secondary battery is discharged and is in a low state-of-charge state, charging the secondary battery for a certain period of time until polarization characteristics are eliminated (ST2); determining whether or not a measurement of open-circuit voltage (OCV) of the secondary battery is feasible (ST6); and when a measurement of the OCV is determined to be feasible, executing a measurement of OCV of the secondary battery (ST7).

## Description

### Technical Field

An embodiment of the present invention relates to an OCV measurement method and an OCV measurement device.

### Background Art

In PTL 1, a technology for measuring open-circuit voltage (hereinafter, referred to as "OCV" as appropriate) when a state of charge (hereinafter, referred to as "SOC" as appropriate) of a chemical battery mounted on a vehicle is high is disclosed.

In the technology disclosed in PTL 1, it is indicated that stable OCV can be measured with respect to a chemical battery in a high SOC state by waiting for a prescribed period of time. It is said that by performing measurement of stable OCV, a state of health (also referred to as "state of degradation", and hereinafter, referred to as "state of health (SOH)" as appropriate) can be determined with high precision.

### Citation List

### Patent Literature

PTL 1: JP 2013-061337 A

### Summary of Invention

### Technical Problem

When the SOH is to be estimated, in order to perform estimation with high precision, it is necessary to measure not only a value of the OCV in a high state-of-charge (high SOC) state but also a value of the OCV in a low state-of-charge (low SOC) state with high precision. In the technology disclosed in PTL 1, in order to ensure precision of measurement in the high SOC state, measurement of stable OCV is performed by waiting for a prescribed period of time, as described above.

On the other hand, measurement of the OCV in the low SOC state is not mentioned. In addition, in a case of a secondary battery mounted on a vehicle, although, for example, the secondary battery is discharged during traveling and, after traveling, is brought into the low SOC state, voltage of the secondary battery in the low SOC state is often unstable. In such an unstable voltage state, the OCV cannot be stably measured.

Further, regarding the secondary battery, stability of voltage can be achieved by resting the secondary battery for a certain period of time even after discharge, such as waiting for a prescribed period of time as described in PTL 1. However, in many cases, a user of a vehicle starts charging immediately after traveling, and since the voltage of the secondary battery does not stabilize during charging, it is likewise difficult to perform a stable measurement of the OCV in the low SOC state.

The present invention has been made to solve the above-described problem, and an object of the present invention is to provide an OCV measurement method and an OCV measurement device capable of grasping a state of health of a secondary battery mounted on a vehicle with high precision by enabling a measurement of OCV with high precision to be performed even when the secondary battery is in a low SOC state.

### Solution to Problem

An OCV measurement device in an embodiment includes: a measurement condition determination unit configured to determine whether or not a measurement of open-circuit voltage (OCV) of a secondary battery is feasible; a charging current control unit configured to, when the secondary battery is discharged and is in a low state-of-charge state, execute charging processing of charging the secondary battery for a certain period of time until polarization characteristics are eliminated; and an OCV measurement unit configured to, when a measurement of the OCV is determined to be feasible by the measurement condition determination unit, execute a measurement of the OCV when the secondary battery is in a low state-of-charge state.

In addition, an OCV measurement method in the embodiment includes: when a secondary battery is discharged and is in a low state-of-charge state, charging the secondary battery for a certain period of time until polarization characteristics are eliminated; determining whether or not a measurement of open-circuit voltage (OCV) of the secondary battery is feasible; and when a measurement of the OCV is determined to be feasible, executing a measurement of OCV of the secondary battery.

### Advantageous Effects of Invention

Since the present invention employs the above-described configuration and measurement method, it is possible to grasp a state of health of a secondary battery mounted on a vehicle with high precision by enabling a measurement of OCV with high precision to be performed even when the secondary battery is in a low SOC state.

### Brief Description of Drawings

FIG. 1 is a block diagram illustrative of an internal configuration of an OCV measurement device in an embodiment of the present invention;
FIG. 2 is a schematic diagram illustrative of change in voltage of a secondary battery mounted on a vehicle over time;
FIG. 3 is a timing diagram in a portion surrounded by a circle in the schematic diagram illustrated in FIG. 2;
FIG. 4 is a flowchart illustrative of a flow of measuring OCV by the OCV measurement device and grasping a state of health of the secondary battery in the embodiment of the present invention; and
FIG. 5 is another flowchart illustrative of the flow of measuring the OCV by the OCV measurement device and grasping the state of health of the secondary battery in the embodiment of the present invention.

### Description of Embodiments

An embodiment of the present invention will be described in detail below with reference to the drawings. Note that the respective drawings are schematic and do not necessarily depict the actual dimensions or precise configurations of practical implementation of the present invention. In addition, embodiments of the present invention to be described below indicate a device and a method to embody the technical idea of the present invention by way of example, and the technical idea of the present invention does not limit the structure, arrangement, and the like of the constituent components to that described below. The technical idea of the present invention can be subjected to a variety of alterations within the technical scope prescribed by the claims described in CLAIMS.

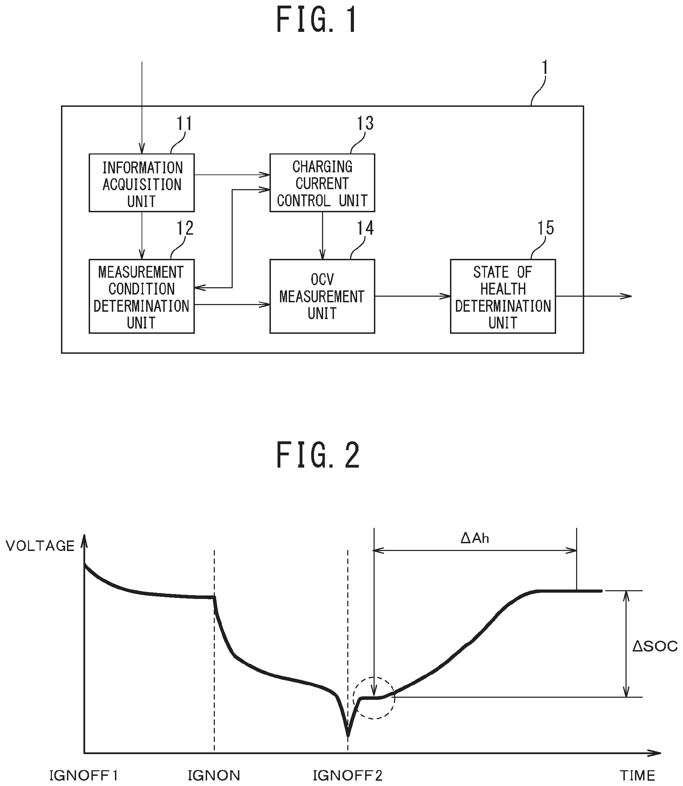

FIG. 1 is a block diagram illustrative of an internal configuration of an OCV measurement device 1 in an embodiment of the present invention. The OCV measurement device 1 is particularly used to measure OCV of a battery (secondary battery) that is mounted on a vehicle and that is in a low SOC state. The OCV measurement device 1 estimates a state of health of the measured secondary battery, using a value of the OCV measured by the OCV measurement device 1.

The above-described point will be described using FIG. 2. FIG. 2 is a schematic diagram illustrative of change in voltage of the secondary battery mounted on the vehicle over time. In FIG. 2, the ordinate represents a value of "voltage", and the abscissa represents "time". The solid line indicates change in the voltage over time.

"IGNOFF" indicates a time point when an ignition is turned from on to off, and conversely, "IGNON" indicates a time point when the ignition is turned from off to on. During a period from "IGNOFF1" to "IGNON", since the vehicle is in a state of not being powered on, that is, the vehicle is in a state of stopping, the voltage of the secondary battery gradually decreases.

When the state of the vehicle changes from this state to an "IGNON" state and the vehicle travels, since power is consumed and the secondary battery is discharged due to the traveling, the voltage of the secondary battery decreases. When the traveling is completed and the vehicle comes to a stop, the ignition is turned off again (at a time point indicated by "IGNOFF2"). In this state, the voltage of the secondary battery has a lowest value due to discharge, as illustrated in FIG. 2. When the traveling of the vehicle is completed, a user, for example, connects a charger to the vehicle and executes charging processing in preparation for the next traveling. Due to the charging processing, the voltage of the secondary battery increases again. This process is indicated by an illustration of gradual increase in the voltage value towards the right-hand side of the abscissa after "IGNOFF2".

In FIG. 2, two downward arrows are illustrated in parallel with the ordinate, which represents voltage. The two arrows indicate timing when the OCV is measured. The arrow on the left-hand side in the drawing indicates a timing when the OCV in the low SOC state is measured, and the arrow on the right-hand side in the drawing indicates a timing when the OCV in the high SOC state is measured. The state of health (SOH) is calculated using the following equation (1).$SOH = \left(ΔAh/ΔSOC\right) / \left(design capacity\right)$ (1)

That is, ΔSOC is calculated using OCV values in the low SOC state and the high SOC state. The state of health (SOH) is calculated by dividing variation (ΔAh) in voltage between the two timings of OCV measurement by the ΔSOH and further dividing a division result by capacity (design capacity) when the secondary battery is brandnew.

In the embodiment of the present invention, the OCV measurement device 1 is mainly used when the OCV in the low SOC state is measured. On the other hand, as described above, calculation of the SOH also requires measurement of the OCV in the high SOC state.

Therefore, as for the OCV in the high SOC state, a value measured using an existing OCV measurement method and measurement device is made use of. Needless to say, the OCV in the high SOC state may be measured using the OCV measurement device 1 in the embodiment of the present invention.

Returning to FIG. 1, the OCV measurement device 1 includes an information acquisition unit 11, a measurement condition determination unit 12, a charging current control unit 13, an OCV measurement unit 14, and a state of health determination unit 15. However, with regard to the constituent components constituting the OCV measurement device 1, only constituent components required for a description of the embodiment of the present invention are illustrated in FIG. 1.

Therefore, the OCV measurement device 1 may include a display device for displaying a finally determined state of health of the secondary battery, an input device through which a parameter and a condition required to measure the OCV are input, or a communication control device for connecting the OCV measurement device 1 to an external device. Alternatively, a storage unit for storing various types of information, such as a condition set to execute measurement of the OCV and a program for measurement of the OCV, may be provided in the OCV measurement device 1.

In addition, the following description is made on the premise that a single device is configured as the OCV measurement device 1. However, the OCV measurement device may be installed inside, for example, a battery controller (a battery management system (BMS)) or a control device controlling the entire vehicle. Alternatively, the OCV measurement device may be a device that is used connected to the above-described devices.

Note that the secondary battery whose state of health is to be estimated in the embodiment of the present invention is a battery that allows a plurality of times of charging and discharging, and, for example, a battery mounted on a vehicle and a storage battery mounted on an electric vehicle and used to provide driving force apply to the secondary battery. In addition, although various types of batteries are available as the "secondary battery", for example, a lithium-ion battery may be employed herein.

The information acquisition unit 11, for example, receives information about whether the battery controller is in an ON state or an OFF state, or acquires information required to measure the OCV and estimate the state of health of the secondary battery, such as information indicating that the charger is connected to the secondary battery.

The measurement condition determination unit 12 determines whether or not the OCV measurement device 1 is able to measure the OCV of the secondary battery that is an object to be measured. For example, the measurement condition determination unit 12 determines whether or not the voltage of the secondary battery has stabilized. That is, when the secondary battery is in a state of having polarization characteristics, there is a possibility that the voltage value does not stabilize, such as the voltage decreasing rapidly. When the second battery is in a state in which the voltage fluctuates and is unstable, it is impossible to measure the OCV, or a measurement cannot be made with high precision. Therefore, it is required to determine whether or not the voltage of the secondary battery has stabilized to an extent that allows the OCV to be measured by the OCV measurement device 1.

For a determination of whether or not the voltage of the secondary battery has stabilized, for example, the following method can be employed. For example, a method is conceivable in which the voltage of the secondary battery is measured, the amount of change (ΔV) in the voltage between a plurality of temporally different time points is acquired, and whether or not the amount of change in the voltage falls within a preset threshold range is determined.

In addition, another method is also conceivable in which, for example, a period of time required for the voltage of the secondary battery that is in a discharged state after the traveling of the vehicle is completed to recover and stabilize is grasped in advance and the voltage of the secondary battery is determined to have stabilized based on the lapse of the period of time.

The charging current control unit 13 controls charging processing when the charging processing is executed on the secondary battery, in order to measure the OCV of the secondary battery in the low SOC state with high precision. The charging current control unit 13 starts charging when detecting that the charger is connected to the vehicle.

That is, in order to measure the OCV with high precision while the secondary battery is in the low SOC state, the voltage of the secondary battery is required to be stable. In a process in which the secondary battery having been discharged due to traveling of the vehicle recovers, it takes time for the voltage to stabilize. In addition, as described above, there is a case where the user starts charging before the voltage stabilizes.

Therefore, in the embodiment of the present invention, it is configured to attempt to actively eliminate polarization characteristics by, for example, making use of charging started by the user and performing the charging processing on the secondary battery for a short period of time. That is, to eliminate the polarization characteristics and stabilize the voltage, charging processing is performed for a certain preset period of time.

On the other hand, when the charging processing is performed for a long period of time, the charging processing is no different from regular charging processing and is to be performed from the low SOC state toward the high SOC state, and during the charging, the voltage becomes unstable instead. Therefore, the charging current control unit 13 performs control to reduce the amount of charging current compared with the amount of charging current during charging when determining that charging time corresponding to the charging current has elapsed and a preset condition is satisfied.

The OCV measurement unit 14 performs measurement of the OCV when the measurement condition determination unit 12 determines that the measurement of the OCV in the low SOC state is feasible. As an OCV measurement method executed by the OCV measurement unit 14, a known method can be used. A measured value of the OCV is transmitted to the state of health determination unit 15.

The state of health determination unit 15 determines a state of health of the secondary battery, using the value of the OCV in the low SOC state measured by the OCV measurement unit 14. Specifically, the state of health determination unit 15 calculates the SOH, using the above-described equation (1), based on the information about the OCV in the low SOC state and the information about the OCV in the high SOC state, and determines the state of health. In addition, the state of health of the secondary battery determined by the state of health determination unit 15 is notified to the user, using, for example, a display device.

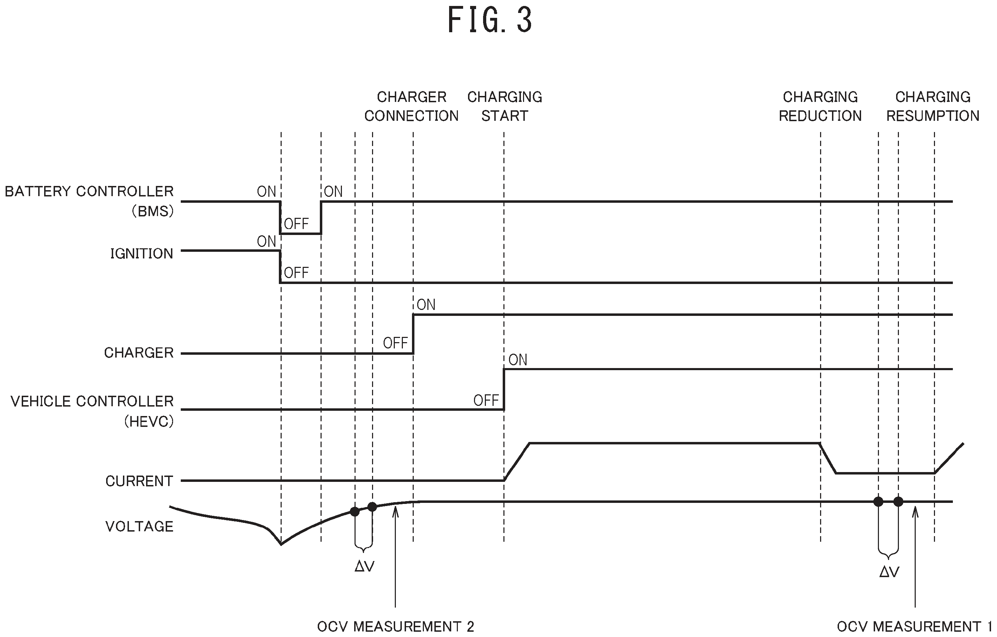

Functions of the constituent components of the OCV measurement device 1 are as described above. Next, actions of the constituent components will be further described below using a timing diagram. FIG. 3 is a timing diagram in a portion surrounded by a circle in the schematic diagram illustrated in FIG. 2.

The timing diagram illustrated in FIG. 3 illustrates actions of the constituent components installed in the vehicle, such as the battery controller, and the charger in the low SOC state by ON and OFF and also illustrates changes in the current and the voltage. On the left-hand side of the timing diagram, the respective devices, namely the "battery controller (BMS)", the "ignition", the "charger", and a "vehicle controller (HEVC)", and "current" and "voltage" are illustrated in this order from the top. In addition, the timing diagram is illustrated in such a manner that time elapses from the left-hand side to the right-hand side of the timing diagram.

On the leftmost side of the timing diagram, a state in which the "ignition" is turned from ON to OFF is illustrated. The "ignition" being turned OFF causes the "battery controller" to also be turned OFF. At this time point, the secondary battery is brought into a state of being most discharged, and a solid line indicating the voltage is illustrated at a lowest position. This position is the position indicated by "IGNOFF2" in FIG. 2.

Once turned OFF at this time point, the "ignition" remains in the same state and is never to be turned ON. In contrast, the "battery controller" is, although being turned OFF at the same time as the "ignition" being turned OFF, immediately turned ON again. As a trigger causing the "battery controller" to be turned ON, for example, an occasion when the user performs some operation on the vehicle is conceivable.

When the "battery controller" is turned ON, the OCV measurement device 1 immediately measures the amount of change in the voltage. That is, the information acquisition unit 11 acquires information indicating that the "battery controller" is turned ON and transmits the acquired information to the measurement condition determination unit 12. Due to the "battery controller" being turned ON, the measurement condition determination unit 12 separately acquires voltage values at a plurality of time points from a voltmeter via the information acquisition unit 11 and calculates the amount of change ΔV in the voltage between the plurality of time points.

Note that although herein, the description is made on the premise that the measurement condition determination unit 12 acquires voltage values from the voltmeter, the measurement condition determination unit 12 may be configured to, for example, acquire the voltage values by itself.

Meanwhile, as described above, the user charges the vehicle for the next traveling after traveling. Specifically, the user plugs the charger into the charging port provided in the vehicle and thereby connects the charger to the vehicle. At this time point, the charger switches from OFF to ON.

The charging is started at a time point when a setup actually required for the charging processing is completed. In addition, when the charging is started, the "vehicle controller (HEVC)" is brought from the OFF state into the ON state. The start of the charging processing causes a value of the current to increase.

However, the charging processing at this time point is only executed to enable the OCV measurement device 1 to measure the OCV when the secondary battery is in the low SOC state. Therefore, the charging current control unit 13 executes charging processing of charging the secondary battery for a certain period of time until the polarization characteristics are eliminated, as described above.

Further, the charging current control unit 13 determines whether or not a preset condition is satisfied immediately before the certain period of time elapses. The reason why the current control unit 13 performs such determination is to confirm whether or not the OCV measurement device 1 can measure the OCV after a lapse of the certain period of time.

As used herein, the preset condition refers to, for example, whether or not a condition of temperature or a condition of the SOC of the secondary battery is satisfied. The former is a condition for confirming whether or not the secondary battery is, for example, in a high temperature state in which the temperature is greater than or equal to 60°C or a low temperature state in which the temperature is less than or equal to 0°C. This is because when the secondary battery is in a state in which the temperature is extremely high or low, it becomes difficult to measure an accurate OCV.

In addition, although the OCV measurement device 1 in the embodiment of the present invention is particularly aimed at measuring the OCV in the low SOC state, in a case where the secondary battery is already in the high SOC state at this time point, the OCV measurement device 1 is not required to subsequently execute the processing of measuring the OCV. Therefore, the charging current control unit 13 determines whether or not the OCV measurement device 1 is able to subsequently execute the processing of measuring the OCV, based on the preset condition of the SOC.

Note that the foregoing conditions may be stored by the charging current control unit 13 or may be stored in, for example, the storage unit, which is not illustrated in the OCV measurement device 1 in FIG 1.

When as a result of the determination, the charging current control unit 13 determines that the preset condition is satisfied, the charging current control unit 13 performs control to reduce the amount of charging current compared with the amount of charging current during charging. That is, the charging current control unit 13 performs control to reduce the amount of charge to the secondary battery.

This is because when the current charging processing is continued, the so-called charging processing of the secondary battery from the low SOC state to the high SOC state is to be performed and, due to the voltage not stabilizing during charging, it eventually becomes impossible to measure the OCV.

On the other hand, the reason why the charging current control unit 13 does not perform processing of suspending (stopping) the charging processing but performs control to reduce the amount of charge as described above is as follows. That is, it is because when the charging is suspended after being started, the vehicle controller, for example, determines that the charger stopped charging, and when the charging is not recovered within a certain period of time, processing when the charging stopped is to be resumed.

Therefore, the charging current control unit 13 performs processing of reducing the amount of charging current in such a way that the amount of charging current becomes lower than the amount of charging current during charging. In this case, the charging current control unit 13 reduces the amount of charging current in such a way that the amount of charging current becomes an amount of charging current large enough to prevent the charging from being determined to be suspended. Therefore, the preset condition herein can be said to be a condition for the charging current control unit 13 to make a determination as to whether or not to reduce the amount of charge to the secondary battery.

This point is illustrated in FIG. 3. That is, although the part "current" in the timing diagram in FIG. 3 illustrates that the current is in a state in which no current flows (the amount of charge is zero) until the start of charging, at the same time as the charging is started, the amount of charging current increases. A certain amount of charging current is supplied to the secondary battery until the amount of charging current is reduced by the charging current control unit 13.

In parallel with the charging processing, whether or not the above-described condition is satisfied is determined by the charging current control unit 13, and when the condition is determined to be satisfied, the amount of charging current is reduced. However, the amount of charging current after reduction by the charging current control unit 13 is not the same as the amount of current before the start of charging. This configuration is aimed at avoiding the reduction being determined as suspension of the charging processing. After the measurement of the OCV by the OCV measurement device 1, which will be described below, is performed, the charging is resumed by the charging current control unit 13.

When the amount of charging current is reduced by the charging current control unit 13, the measurement condition determination unit 12 determines whether or not the polarization characteristics of the secondary battery have been eliminated, that is, whether or not the voltage has stabilized. For that purpose, the measurement condition determination unit 12 calculates a value of ΔV and determines whether or not ΔV falls within a preset threshold range, as illustrated in FIG. 3. When as a result, it is determined that the voltage of the secondary battery is stable, the OCV measurement unit 14 measures the OCV of the secondary battery ("OCV measurement 1" in the timing diagram in FIG. 3).

Note that the reason why the measurement condition determination unit 12 does not perform the above-described determination immediately after the amount of charging current is reduced by the charging current control unit 13 is that it is considered that the voltage is not stable immediately after the charging current is reduced. Therefore, the determination is performed after a short period of time.

Information about the OCV in the low SOC state measured by the OCV measurement unit 14 is transmitted to the state of health determination unit 15. The state of health determination unit 15 calculates the SOH using the above-described equation (1), based on separately acquired information about the OCV in the high SOC state in conjunction with the acquired information about the OCV in the low SOC state, and determines the state of health of the secondary battery.

Note that with regard to the information about the OCV in the high SOC state, the state of health determination unit 15 may acquire the information from another measurement device or acquire a measurement result measured by the OCV measurement device 1 in the embodiment of the present invention. In addition, the value of "ΔAh" may be calculated by, for example, the state of health determination unit 15.

In addition, the "design capacity" is measured before shipment of a secondary battery (battery) from a factory, and a measured value is grasped as a design capacity with respect to each secondary battery. Therefore, the design capacity is stored in advance in, for example, a storage unit as an invariable parameter. Accordingly, the state of health determination unit 15 may acquire information about the design capacity from the storage unit.

A flow of measurement processing of the OCV in the low SOC state performed by the OCV measurement device 1 is basically as described above. However, a case is conceivable where, for example, the OCV in the low SOC state can be measured before the processing of reducing the amount of charging current performed by the charging current control unit 13 is executed.

That is, the above-described case is a case where when, for example, the measurement condition determination unit 12 determines whether or not the voltage of the secondary battery is stable at a time point after the ignition is turned OFF after traveling of the vehicle ("IGNOFF2" in FIG. 2) and before the charger is connected to the vehicle and charging is started, it is determined that the voltage is stable.

Alternatively, a case where the measurement condition determination unit 12 determines that a predetermined period of time has elapsed after the ignition is turned OFF in the vehicle also applies to the above-described case. As described above, even in the secondary battery that is in the discharged state due to traveling, the polarization characteristics are eliminated and the voltage stabilizes after, for example, a period of 6 hours elapses. That is, the above-described case is a case where time has elapsed without the user performing charging processing.

In these cases, it is considered that it is not necessary for the charging current control unit 13 to stabilize the voltage of the secondary battery by charging the secondary battery and the OCV in the low SOC state can be immediately measured.

Therefore, when the measurement condition determination unit 12 determines that the condition as described above is satisfied, the OCV measurement device 1 measures the OCV before the charger is connected. "OCV Measurement 2" illustrated in the timing diagram in FIG. 3 indicates the measurement of the OCV executed at such timing.

Note that in a case where when the measurement condition determination unit 12 determines whether or not the voltage of the secondary battery has stabilized, the measurement condition determination unit 12 determines that the voltage has not stabilized or in a case where when the charging current control unit 13 determines whether or not the charging current is to be reduced, the charging current control unit 13 determines not to reduce the charging current, the measurement of the OCV performed by the OCV measurement device 1 is not executed. Therefore, the SOH is not calculated, and neither is a determination of the state of health of the secondary battery made.

### (Operation)

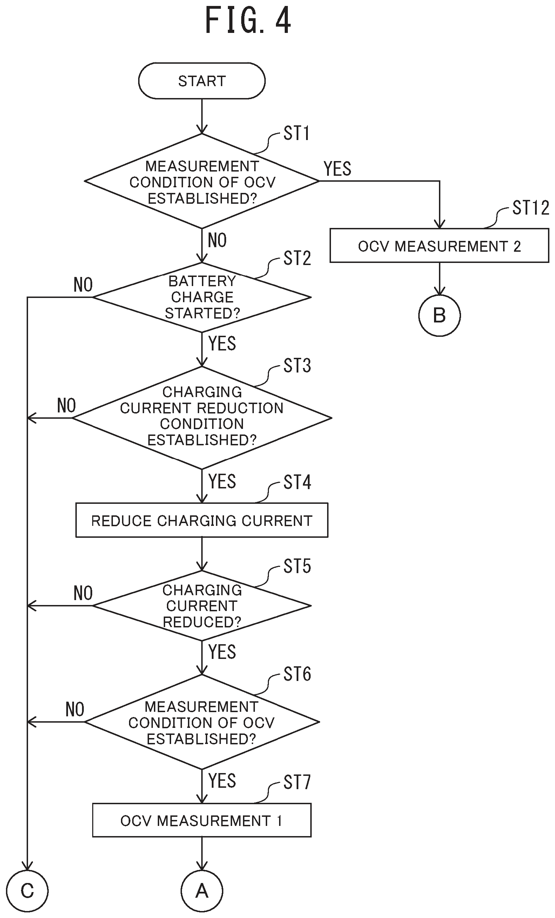

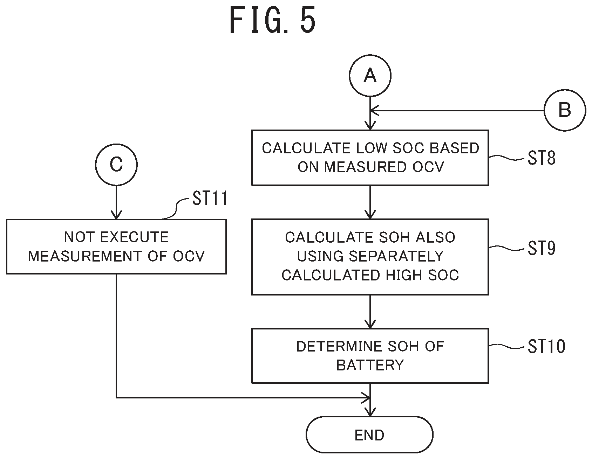

Next, a processing flow of the measurement of the OCV in the low SOC state performed by the OCV measurement device 1 will be described. FIGS. 4 and 5 are a flowchart illustrative of a flow of the OCV measurement device 1 measuring the OCV and grasping the state of health of the secondary battery in the embodiment of the present invention.

Note that in the flowchart illustrated in FIG. 4, the processing is started when the vehicle has completed traveling and the secondary battery is in a state in which the voltage is reduced due to discharge during the traveling. This state is the state indicated by "IGNOFF2" in FIG. 2.

In the timing diagram in FIG. 3, a time point when the battery controller transitions from the OFF state to the ON state after the time point indicated by "IGNOFF2" in FIG. 2 is a start time point of the processing in the flowchart in FIG. 4. In addition, in the flowchart in FIG. 4 or 5, the secondary battery is referred to as "battery".

First, the measurement condition determination unit 12 determines whether or not the OCV in the low SOC state can be measured by the OCV measurement device 1 (ST1). A measurement condition in this step is, for example, whether the amount of change in voltage falls within a certain range when compared with a threshold value or whether or not, with regard to the secondary battery that is an object to be measured, the ignition has been turned off and a preset period of time has elapsed.

When the measurement condition determination unit 12 has made a determination of the measurement condition and the measurement condition of the OCV is not established (NO in ST1), the measurement condition determination unit 12 further determines whether or not a charger is connected to the battery (secondary battery), that is, whether or not the charging processing is started (ST2).

When it is determined that the charging processing is started (YES in ST2), the control of the charging current is performed by the charging current control unit 13 for a certain period of time. The charging current control unit 13 determines, before a lapse of the certain period of time, whether or not the condition for reducing the charging current is established (ST3).

The condition for reducing the charging current in this step is, as described above, a condition requiring that, for example, a condition of the temperature or SOC of the secondary battery is established. When the charging current control unit 13 determines that the condition for reducing the charging current is established (YES in ST3), the charging current control unit 13 reduces the charging current (ST4).

The measurement condition determination unit 12 determines whether or not the charging current is reduced by the charging current control unit 13 (ST5) and, when determining that the charging current is reduced (YES in ST5), next determines whether or not the condition for measurement of the OCV is established (ST6). In this step, as described so far, the measurement condition determination unit 12 determines whether or not the voltage has stabilized by, for example, comparing the amount of change in the voltage with a threshold value.

When as a result, the measurement condition determination unit 12 determines that the voltage is stable (YES in ST6), the result is transmitted to the OCV measurement unit 14, and the measurement of the OCV is executed by the OCV measurement unit 14 (ST7). This state is a state at a timing indicated as "OCV Measurement 1" in the timing diagram in FIG. 3.

The OCV measurement unit 14 transmits information about the measured OCV to the state of health determination unit 15. The state of health determination unit 15 calculates a low SOC, based on the information about the measured OCV (ST8 in FIG. 5). Further, the state of health determination unit 15 calculates an SOH, based on the above-described equation (1), using a separately calculated high SOC as well (ST9). The state of health determination unit 15 determines the state of health of the secondary battery, based on the calculated SOH (ST10).

In contrast, in each of the following cases, the measurement of the OCV is not executed (ST11 in FIG. 5). That is, in a case where the battery is not to be charged (NO in ST2), in a case where it is determined that the condition for reducing the charging current by the charging current control unit 13 is not established (NO in ST3), in a case where it is determined by the measurement condition determination unit 12 that the charging current is not reduced (NO in ST5), or in a case where the condition for the measurement of the OCV is not established (NO of ST6), the measurement of the OCV is not executed. In the foregoing cases, the SOH is not calculated, and neither is a determination of the state of health of the secondary battery made.

Further, in a case where when the determination of the measurement condition of the OCV is made by the measurement condition determination unit 12 (ST1) before the charging of the secondary battery is started (ST2), it is determined that the measurement condition is established (YES in ST1), the OCV is measured by the OCV measurement device 1 at this time point (ST12). The measurement at this time point corresponds to "OCV measurement 2" in the timing diagram illustrated in FIG. 3.

The low SOC is calculated based on the measurement of the OCV, and the SOH is calculated using information about the high SOC, which is separately grasped, and the like. As a result, in the state of health determination unit 15, a determination is made as to the state of health of the secondary battery (ST8 to ST10 in FIG. 5).

As described in the foregoing, use of the OCV measurement method and the OCV measurement device in the embodiment of the present invention enables measurement of OCV with high precision to be performed even when the secondary battery mounted on the vehicle is in the low SOC state and the state of health of the secondary battery to be grasped with high precision.

In addition, in a process where the voltage recovers after the discharge of the secondary battery is terminated, it becomes possible to measure the OCV in the low SOC state at an as early stage as possible. Therefore, it is possible to greatly increase a difference between the OCV in the low SOC state and the OCV in the high SOC state, which are used to measure the state of health (SOH) of the secondary battery. Since therefore, the value of ΔSOC can be increased with respect to ΔAh, the state of health of the secondary battery can be estimated with higher precision.

Note that the description so far is made on the premise that when the OCV measurement device 1 performs charging of the secondary battery in order to measure the OCV in the low SOC state, the OCV measurement device 1 executes the charging processing of charging the secondary battery for a certain period of time until the polarization characteristics of the secondary battery are eliminated. However, although the polarization characteristics of a secondary battery differ depending on load current, there are various types of chargers to be connected to the vehicle, and load currents flowing during charging processing also differ from each other.

Therefore, the charging current control unit 13 may control the charging processing in such a way as to perform charging in accordance with charging time corresponding to charging current with respect to each type of connected charger, after charging to the secondary battery is started. That is, in a case where the charging current control unit 13 performs such control, when the charging current to the secondary battery is large, the charging time becomes shorter. In contrast, when the charging current is small, the charging time becomes longer.

In addition, the determination of whether or not the polarization characteristics of the secondary battery have been eliminated, that is, the determination of whether or not the measurement condition is satisfied, has been described so far on the assumption that the determination is made by comparing the amount of change in the voltage with a threshold value.

However, instead of such a method, a method in which, for example, a period of time until the voltage stabilizes while the vehicle is stopped and the state of charge of the secondary battery gradually recovers is set in advance and the measurement condition is determined to be satisfied based on the lapse of the set period of time can be employed. In addition, it is also possible to use the method using the amount of change in the voltage in combination with the method using time.

### (Advantageous effects of Embodiment)

(1) An OCV measurement method includes: when a secondary battery is discharged and is in a low state-of-charge state, charging the secondary battery for a certain period of time until polarization characteristics are eliminated; determining whether or not a measurement of open-circuit voltage (OCV) of the secondary battery is feasible; and when a measurement of the OCV is determined to be feasible, executing a measurement of OCV of the secondary battery.

By measuring the OCV in the low SOC state using the OCV measurement method as described above, it is possible to measure the OCV with high precision even in the low SOC state. In particular, by executing charging processing of charging the secondary battery that is discharged and is in the low state-of-charge (low SOC) state for a certain period of time, it is possible to eliminate polarization characteristics in the secondary battery.

(2) The OCV measurement method includes: determining whether or not charging time corresponding to charging current has elapsed after charging of the secondary battery is started and a preset condition is satisfied; and when the foregoing conditions are satisfied, performing control to reduce an amount of charging current compared with the amount of charging current during charging.

Since by a charging current control unit performing such control, it is possible to eliminate the polarization characteristics of the secondary battery through charging processing and prevent subsequent execution of charging processing, the OCV can be measured while the voltage is stable. In addition, by performing control to reduce the amount of charging current to lower than the amount of charging current during charging to an extent that does not suspend the charging processing, it is possible to execute the measurement processing of the OCV while avoiding a situation in which the charging processing is determined to be suspended.

(3) Determination of whether or not a measurement of the OCV is feasible includes comparing an amount of change in voltage of the secondary battery with a preset threshold value and, when the amount of change in voltage is determined to be stable, determining that a measurement of the OCV is feasible.

By determining whether or not the voltage of the secondary battery has stabilized after the charging current control unit reduces the amount of charging current, it is possible to execute a measurement of OCV with higher precision.

(4) The OCV measurement method includes making a determination as to whether or not a measurement of the OCV is feasible before the charging the secondary battery.

In the OCV measurement method in the embodiment of the present invention, the secondary battery that is an object to be measured is charged before performing the OCV measurement as described above, and further, a determination is made as to whether or not the voltage has stabilized. Therefore, it becomes possible to execute the measurement of the OCV with higher precision.

(5) The OCV measurement method includes determining whether or not charging time corresponding to charging current has elapsed after charging of the secondary battery is started and a preset condition is satisfied and, when the preset condition is determined not to be satisfied, performs control to maintain the amount of charging current.

Although the measurement of the OCV is basically performed after charging of the secondary battery after discharge is performed, depending on conditions, there is a case where the OCV can be measured without performing charging. Therefore, in order to enable the OCV to be measured even in such a case, the measurement condition determination unit determines a feasibility of a measurement of the OCV before the charging of the secondary battery is performed.

(6) The OCV measure method includes, after the executing a measurement of the OCV, determining a state of health of the secondary battery, using information about the measured OCV.

By executing the measurement of the OCV as described above, not only can information about the OCV be obtained, but also the state of health of the secondary battery can be determined by calculating the SOC and SOH, using the above-described information about the OCV.

(7) The determining a state of health of the secondary battery determines a state of health of the secondary battery, using information about OCV when the secondary battery is in a low state-of-charge state and information about OCV when the secondary battery is charged and is in a high state-of-charge state.

By executing such determination processing of the state of health, it is possible to determine the state of health of the secondary battery with high precision, using information about the OCV measured with high precision.

(8) An OCV measurement device is an OCV measurement device configured to measure open-circuit voltage (OCV) of a secondary battery and includes: a measurement condition determination unit configured to determine whether or not a measurement of the OCV is feasible; a charging current control unit configured to, when the secondary battery is discharged and is in a low state-of-charge state, execute charging processing of charging the secondary battery for a certain period of time until polarization characteristics are eliminated; and an OCV measurement unit configured to, when a measurement of the OCV is determined to be feasible by the measurement condition determination unit, execute a measurement of the OCV when the secondary battery is in a low state-of-charge state.

By measuring the OCV in the low SOC state using the OCV measurement device as described above, it is possible to measure the OCV with high precision even in the low SOC state. In particular, by executing charging processing of charging the secondary battery that is discharged and is in the low state-of-charge (low SOC) state for a certain period of time, it is possible to eliminate polarization characteristics in the secondary battery.

### Reference Signs List

- 1: OCV measurement device
- 11: Information acquisition unit
- 12: Measurement condition determination unit
- 13: Charging current control unit
- 14: OCV measurement unit
- 15: State of health determination unit

## Claims

1. An OCV measurement method comprising:
when a secondary battery is discharged and is in a low state-of-charge state, charging the secondary battery for a certain period of time until polarization characteristics are eliminated;
determining whether or not a measurement of open-circuit voltage (OCV) of the secondary battery is feasible; and
when a measurement of the OCV is determined to be feasible, executing a measurement of OCV of the secondary battery.

2. The OCV measurement method according to claim 1 comprising:
determining whether or not charging time corresponding to charging current has elapsed after charging of the secondary battery is started and a preset condition is satisfied; and
when the foregoing conditions are satisfied, performing control to reduce an amount of charging current compared with the amount of charging current during charging.

3. The OCV measurement method according to claim 1, wherein determination of whether or not a measurement of the OCV is feasible includes comparing an amount of change in voltage of the secondary battery with a preset threshold value and, when the amount of change in voltage is determined to be stable, determining that a measurement of the OCV is feasible.

4. The OCV measurement method according to claim 2, wherein determination of whether or not a measurement of the OCV is feasible is comparing an amount of change in voltage of the secondary battery with a preset threshold value and, when the amount of change in voltage is determined to be stable, determining that a measurement of the OCV is feasible.

5. The OCV measurement method according to claim 1, wherein the OCV measurement method includes making a determination as to whether or not a measurement of the OCV is feasible before the charging the secondary battery.

6. The OCV measurement device according to claim 1 comprising
determining whether or not charging time corresponding to charging current has elapsed after charging of the secondary battery is started and a preset condition is satisfied,
wherein when the preset condition is determined not to be satisfied, the OCV measurement method performs control to maintain the amount of charging current.

7. The OCV measurement method according to any one of claims 1 to 6 comprising
after the executing a measurement of the OCV,
determining a state of health of the secondary battery, using information about the measured OCV.

8. The OCV measurement method according to claim 7, wherein the determining a state of health of the secondary battery
determines a state of health of the secondary battery, using information about OCV when the secondary battery is in a low state-of-charge state and information about OCV when the secondary battery is charged and is in a high state-of-charge state.

9. An OCV measurement device comprising:
a measurement condition determination unit configured to determine whether or not a measurement of open-circuit voltage (OCV) of a secondary battery is feasible;
a charging current control unit configured to, when the secondary battery is discharged and is in a low state-of-charge state, execute charging processing of charging the secondary battery for a certain period of time until polarization characteristics are eliminated; and
an OCV measurement unit configured to, when a measurement of the OCV is determined to be feasible by the measurement condition determination unit, execute a measurement of the OCV when the secondary battery is in a low state-of-charge state.
